# FASCICULE DE BREVET EUROPEEN

(11) **EP 4 409 634 B1**
(45) Date de publication et mention de la délivrance du brevet: **05.11.2025**
(21) Numéro de dépôt: 22786042.6
(22) Date de dépôt: 27.09.2022
(51) Int. Cl.: H01L 23/522, H01L 25/065, H01L 23/00, H01L 23/66, H01L 23/64, H10D 84/08, H10D 84/00

(54) **CIRCUIT INTÉGRÉ À PUCES SUPERPOSÉES ET CONNEXION CAPACITIVE**
INTEGRIERTE SCHALTUNG MIT GESTAPELTEN CHIPS UND KAPAZITIVER VERBINDUNG
INTEGRATED CIRCUIT WITH STACKED CHIPS AND CAPACITIVE CONNECTION

(30) Priorité: 28.09.2021 FR 2110183
(43) Date de publication de la demande: 07.08.2024
(73) Titulaire: Commissariat à l'Energie Atomique et aux Energies Alternatives, 75015 Paris (FR)
(72) Inventeur: BELOT, Didier, 38054 Grenoble Cedex 09 (FR); BOUTRY, Hervé, 38054 Grenoble Cedex 09 (FR); DORE, Jean-Baptiste, 38054 Grenoble Cedex 09 (FR); VALORGE, Olivier, 38054 Grenoble Cedex 09 (FR)
(74) Mandataire: Cabinet Camus Lebkiri
(86) Numéro de dépôt international: PCT/EP2022/076764
(87) Numéro de publication internationale: WO 2023/052327

(56) Documents cités:
- WO-A1-2016/105425
- US-A- 5 404 265
- US-A1- 2011 049 673
- US-A1- 2016 359 456
- US-A1- 2017 141 115
- US-A1- 2018 240 860
- US-B1- 10 263 170

## Description

### DOMAINE TECHNIQUE

De manière générale, le domaine technique est celui de la micro-électronique, en particulier celui des circuits intégrés réalisés sous la forme d'empilements de plusieurs puces assemblées ensemble, et connectées électriquement ensemble.

### ARRIERE-PLAN TECHNOLOGIQUE

Dans le domaine de la micro-électronique, il est fréquent d'assembler ensemble plusieurs puces ayant des fonctions différentes, notamment des puces obtenues par des techniques de fabrications différentes. Le circuit intégré ainsi obtenu a alors la structure d'un empilement tridimensionnel.

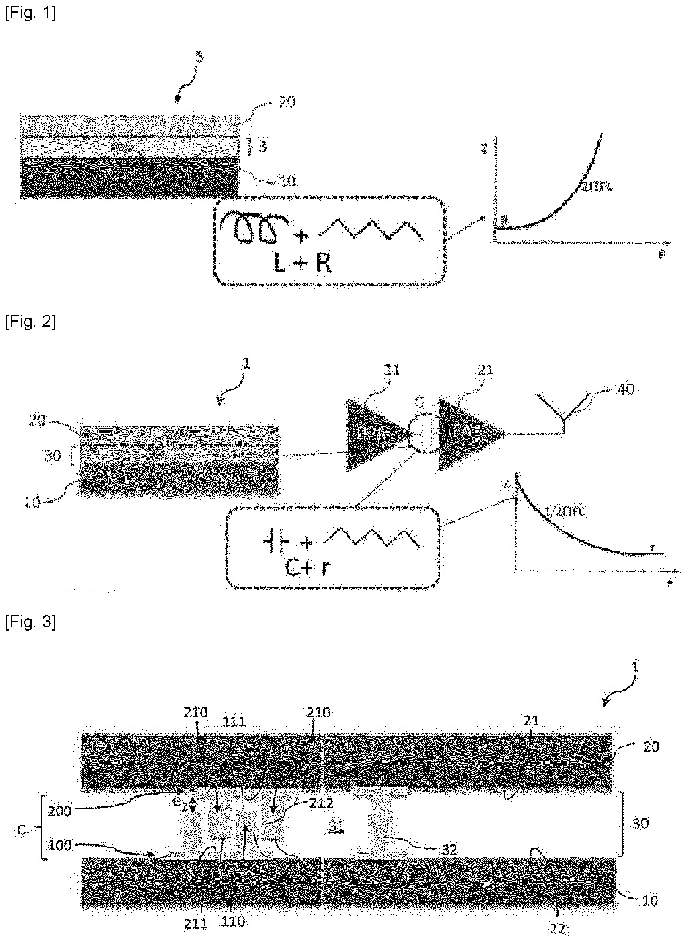

Un tel circuit est représenté schématiquement sur la figure 1. Ce circuit 5 comporte une première puce 10 et une deuxième puce 20, assemblées l'une sur l'autre. La première puce est connectée électriquement à la deuxième puce au moyen de micropiliers 4 qui s'étendent chacun de la première puce à la deuxième puce, à travers une couche de jonction 3 (par exemple en oxyde, ou en polymère), qui lie les puces entre elles. Un tel micropilier comprend généralement deux demi-micropiliers, c'est-à-dire deux micropoteaux (souvent appelés « post », en anglais, l'un réalisé sur la première puce, et l'autre sur la deuxième puce) raccordés l'un à l'autre par une microbille de soudure (formée par exemple à partir d'un matériau à base d'étain). Un tel micropilier a par exemple une hauteur totale d'une dizaine de microns. Une telle connexion électrique est essentiellement équivalente à une résistance R en série avec une inductance L (inductance propre du pilier ; pilier qui forme en quelque sorte une portion de fil électrique conducteur). A haute fréquence, l'impédance totale associée à cette connexion devient importante à cause de cette composante inductive (comme illustré sur la figure 1), ce qui peut gêner la transmission de signaux d'une puce à l'autre en entrainant des réflexions indésirables lors du passage d'une puce à l'autre et des pertes causées par cette impédance élevée.

Le document US2011/0049673 A décrit un condensateur de découplage à nanopiliers.

### RESUME

Dans ce contexte, on propose un circuit intégré comprenant une première puce et une deuxième puce assemblées l'une sur l'autre, la première puce étant connectée électriquement à la deuxième puce *par un condensateur de couplage* qui est situé dans une zone de jonction entre puces, entre la première puce et la deuxième puce, et qui permet une liaison électrique à haute fréquence (fréquence supérieure à 10, ou même supérieure à 100 ou 300 GHz) entre ces deux puces.

Un tel condensateur, de capacité C, a une impédance qui varie comme 1(*ljC2πf*), et qui décroit donc lorsque la fréquence f augmente, devenant très faible à haute fréquence. Il est donc bien adapté pour réaliser une liaison dans le but de transmettre un signal électrique à haute fréquence, de l'une à l'autre. Dans un circuit intégré, les questions d'encombrement sont toutefois critiques, en général, et l'on pourrait donc, à première vue, être dissuadé d'employer un tel condensateur, par nature assez encombrant, pour réaliser cette connexion. Mais justement, pour des fréquences très élevées, par exemple de l'ordre de la centaine de gigahertz ou plus, même un condensateur de faible capacité électrique (par exemple de l'ordre d'une cinquantaine de femtofarads), peu encombrant, permet d'obtenir une impédance de connexion faible, par exemple inférieure à une dizaine d'Ohms. Autrement dit, dans cette gamme de fréquence, ce type de connexion par condensateur de couplage devient intéressante en termes d'encombrement et d'intégration.

Agencer ce condensateur *dans la zone de jonction* entre puces permet d'ailleurs d'exploiter avantageusement l'espace disponible dans cette zone interstitielle, pour y réaliser une fonction plus élaborée qu'une connexion DC ou une liaison mécanique entre puces.

Le condensateur de couplage en question peut comprendre :
- une première armature conductrice, en contact électrique avec la première puce, et
- une deuxième armature conductrice en contact électrique avec la deuxième puce,
- une partie au moins de la première armature étant située en vis-à-vis de la deuxième armature, les première et deuxième armatures étant isolées électriquement l'une de l'autre,
- une partie au moins de la première armature étant formée par un ou plusieurs micropoteaux électriquement conducteurs, qui s'étendent chacun à partir de la première puce, en direction de la deuxième puce.

Par « micropoteau » on désigne un élément, par exemple de forme cylindrique, faisant saillie par rapport à la puce considérée, s'étendant en direction de l'autre puce, mais pas totalement jusqu'à l'autre puce. Les dimensions (diamètre, hauteur) d'un tel micropoteau sont typiquement supérieures à 1 micron, et inférieures à 100 microns, par exemple comprises entre 10 et 50 microns.

Par « micropilier », ou, de manière équivalente, par « micropilier complet » on désigne un élément qui s'étend depuis l'une des deux puces jusqu'à l'autre puce, en raccordant directement ces deux puces entre elles. Un tel micropilier est par exemple formé de deux micropoteaux, l'un réalisé sur la première puce, et l'autre sur la deuxième puce, raccordés l'un à l'autre par une microbille de soudure.

Les micropoteaux et les micropiliers en question sont électriquement conducteurs. Ils sont typiquement formés d'un ou plusieurs matériaux métalliques. Chaque micropoteau peut être d'un seul tenant, formé d'un même matériau métallique (par exemple du cuivre ou un alliage à base de cuivre), ou comprendre plusieurs portions (plusieurs couches) formés de matériaux métalliques différents.

Par ailleurs, par « armature », on désigne une structure électriquement conductrice, typiquement à base de métal, dont la forme peut être simple (par exemple une forme de plaque) ou plus complexe. Les différents éléments de l'armature sont en contact électrique les uns avec les autres. En d'autres termes, par « armature », on désigne l'une des deux électrodes du condensateur de couplage.

Réaliser l'une des armatures du condensateur à partir d'un ou plusieurs micropoteaux est particulièrement intéressant. En effet, la réalisation de tels micropoteaux (qui servent de base aux micropiliers mentionnés dans la partie relative à l'arrière-plan technologique) est bien maitrisée technologiquement, en particulier dans une telle zone de jonction entre puces. Cela permet par ailleurs de rapprocher certaines portions de la première armature de la deuxième armature, pour obtenir une capacité par unité de surface élevée malgré la distance qui sépare les deux puces dans la zone de jonction entre puces. En effet, cette distance est typiquement supérieure à 5 microns, pour un assemblage entre puces par micropiliers (du fait des dimensions des micro-poteaux eux-mêmes, et de la microbille de soudure qui assure la jonction entre eux). On notera d'ailleurs que, en général, dans le circuit intégré en question, des connexions DC entre les deux puces (connexion classique, par conduction électrique) sont réalisées en plus de la connexion capacitive haute fréquence mentionnée plus haut, ces connexions DC étant réalisées au moyen d'un ou plusieurs micropiliers complets. L'écart entre puces est alors assez important (plusieurs microns), et il est donc particulièrement intéressant de rapprocher les deux armatures l'une de l'autre, au moins par endroits, pour augmenter la capacité du condensateur (ce qui est obtenu astucieusement par l'emploi d'un ou plusieurs micropoteaux, reliés électriquement à la première puce, mais isolés de la deuxième armature du condensateur).

Dans la présente demande, on entend par puce une structure globalement plane (dont la forme d'ensemble est celle d'une petite plaque), à base d'un ou plusieurs matériaux semi-conducteurs (ainsi que d'autres matériaux, en particulier des matériaux métalliques et/ou des oxydes isolant électriquement), et pouvant intégrer différents composants, actifs ou passifs (transistor, diode, résistance, structure rayonnante ou de guidage). La puce en question peut être formée par un wafer complet (et fonctionnalisé), ou par une portion seulement d'un tel wafer (c'est-à-dire par un Die).

La première puce et la deuxième puce sont assemblées l'une sur l'autre en ce sens qu'elles sont liées (liées mécaniquement) l'une à l'autre, avec la deuxième puce située juste au-dessus de la première puce, parallèlement à celle-ci, quasiment contre la première puce. En d'autres termes, la première puce présente une première surface (qui délimite la première puce), la deuxième puce présente une deuxième surface (qui délimite la première puce), et les deux puces sont assemblées de manière à ce que la première surface s'étende en vis-à-vis de la deuxième surface, parallèlement et à distance réduite de celle-ci (par exemple avec un écart inférieur à 30 microns). Les deux puces sont ainsi assemblées l'une à l'autre au niveau de ces première et deuxième surfaces.

La zone de jonction mentionnée plus haut, qui est une zone d'assemblage entre puces et qui constitue une zone interstitielle entre puces, est délimitée par les première et deuxième surfaces en question.

En pratique, la liaison mécanique entre puces est obtenue en faisant adhérer certains éléments de la première puce, qui s'étendent dans la zone d'assemblage en question (par exemple des micropoteaux), avec des éléments de la deuxième puce (là aussi des micropoteaux, par exemple). Un matériau de remplissage optionnel, par exemple un polymère (ou un oxyde, typiquement un oxyde de silicium), peut remplir la partie inoccupée de la zone d'assemblage, pour obtenir un assemblage plus robuste mécaniquement, en formant une couche de liaison entre puces.

La technologie d'assemblage employée ici est typiquement une technologie de type micropiliers, parfois appelée « Copper Pillar bonding » ou « Copper Pillar Bump » en anglais.

Outre les caractéristiques présentées ci-dessus, le dispositif présenté ci-dessus peut présenter une ou plusieurs des caractéristiques optionnelles suivantes, considérées individuellement ou selon toutes les combinaisons techniquement envisageables :
- chaque micropoteau s'étend perpendiculairement à la première puce, depuis la première puce jusqu'à une face d'extrémité du micropoteau ;
- la deuxième armature comprend, pour chaque micropoteau, une face ou une portion de face plane située en vis-à-vis et à une distance réduite de la face d'extrémité de ce micropoteau ;
- une partie au moins de la deuxième armature est formée par un ou plusieurs micropoteaux supplémentaires électriquement conducteurs, qui s'étendent chacun en direction de la première puce, depuis la deuxième puce jusqu'à une face d'extrémité du micropoteau supplémentaire ;
- chaque micropoteau, ainsi que chaque micropoteau supplémentaire, est délimité latéralement par une surface latérale, et au moins certains des micropoteaux supplémentaires sont décalés latéralement par rapport auxdits micropoteaux, leurs surfaces latérales respectives étant situées chacune en vis-à-vis de la surface latérale de l'un desdits micropoteaux ; cette disposition contribuent à augmenter la capacité du condensateur ; elle autorise par ailleurs des tolérances assez importantes en termes d'alignement latéral entre puces ;
- au moins certains desdits micropoteaux supplémentaires sont intercalés entre des micropoteaux de la première armature ; Cela permet d'augmenter la densité surfacique de micropoteaux, et la capacité du condensateur ;
- au moins certains des micropoteaux supplémentaires s'étendent chacun en vis-à-vis de l'un desdits micropoteaux, la face d'extrémité du micropoteau supplémentaire considéré étant située en vis-à-vis et à distance réduite de la face d'extrémité du micropoteau correspondant, en étant isolée électriquement de la face d'extrémité de ce micropoteau ;
- la deuxième armature comprend une plaque plane qui s'étend en face du ou desdits micropoteaux ;
- la deuxième armature est dépourvue de micropoteau ; cette disposition facilite la fabrication ;
- lesdits micropoteaux sont disposés périodiquement en formant un réseau régulier ;
- une partie au moins de la première armature est séparée de la deuxième armature par une distance inférieure à 2 microns, voire inférieure à 0,5 micron ;
- le condensateur de couplage a une capacité électrique moyenne par unité de surface supérieure ou égale à 5 picofarad par millimètre carré ;
- le condensateur de couplage a une capacité électrique supérieure ou égale à 50 femtofarad ;
- la première puce est formée au moins en partie, voire majoritairement d'un premier type de matériau semi-conducteur tandis que la deuxième puce est formée au moins en partie, voire majoritairement d'un deuxième type de matériau semi-conducteur différent du premier type de matériau semiconducteur ; le premier type de matériau est par exemple du silicium ; le deuxième type de matériau est par exemple un semiconducteur de type III-V ; dans le domaine de la micro-électronique, le type de matériau semiconducteur et les technologies de fabrication employées peuvent être assez différentes selon le type de fonction à réaliser ; assembler ainsi deux puces réalisées à base de matériaux semi-conducteurs de type différents permet donc d'intégrer dans ce même circuit des fonctions assez différentes ;
- la première armature du condensateur de couplage est reliée électriquement, par exemple par un conducteur électrique, à un premier composant électronique de type transistor, diode, amplificateur, antenne, guide d'onde ou filtre, tandis que sa deuxième armature est reliée électriquement , par exemple par un conducteur électrique, à un deuxième composant électronique de type transistor, diode, amplificateur, antenne, guide d'onde ou filtre ;
- le premier composant électronique est configuré pour générer, émettre, transmettre ou filtrer un signal électrique de fréquence supérieure ou égale à 10 GHz, voire supérieure à 100 ou même 300 GHz, ou même plus (le spectre du signal en question peut par exemple s'étendre jusqu'à 325 GHz) ;
- le premier composant électronique et/ou le deuxième composant électronique est un composant actif (alimenté électriquement).

La présente technologie et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif.
[Fig. 1] La figure 1 représente schématiquement un circuit intégré à puces superposées de l'art antérieur.
[Fig. 2] La figure 2 représente schématiquement un circuit intégré selon un premier mode de réalisation, comprenant deux puces assemblées l'une sur l'autre et reliées électriquement l'une à l'autre par un condensateur de couplage.
[Fig. 3] La figure 3 représente schématiquement le circuit intégré de la figure 2, vu de côté.
[Fig. 4] La figure 4 représente schématiquement un ensemble de micropoteaux du condensateur de couplage en question, vu de dessus.
[Fig. 5] La figure 5 représente schématiquement le condensateur de couplage, en perspective.
[Fig. 6] La figure 6 représente le circuit intégré des figures 2 et 3, sous la forme d'un schéma électrique équivalent.
[Fig. 7] La figure 7 représente, sous la forme d'un schéma électrique équivalent, un circuit intégré selon un deuxième mode de réalisation, comprenant lui aussi deux puces assemblées l'une sur l'autre et reliées par un condensateur de couplage.
[Fig. 8] La figure 8 représente schématiquement un circuit intégré selon un troisième mode de réalisation, comprenant lui aussi deux puces assemblées l'une sur l'autre et reliées par un condensateur de couplage à micropoteaux.
[Fig. 9] La figure 9 représente schématiquement un circuit intégré selon un quatrième mode de réalisation, comprenant lui aussi deux puces assemblées l'une sur l'autre et reliées par un condensateur de couplage à micropoteaux.

### DESCRIPTION DETAILLEE

Un exemple de circuit intégré 1 à puces empilées, reliées par le type de connexion capacitive particulier présenté plus haut, est représenté schématiquement sur la figure 2. Dans cet exemple, le circuit est destiné à émettre un signal à très haute fréquence, en l'occurrence à une fréquence f supérieure à 100 GHz, et même supérieure à 300 GHz.

Il comprend une première puce 10, ici à base de silicium, et une deuxième puce 20, ici à base d'Arseniure de Gallium GaAs (plus généralement, à base d'un semiconducteur de type III-V, c'est-à-dire comprenant un élément de la colonne V du tableau périodique des éléments, par exemple de l'azote N ou du phosphore P, associé à un ou plusieurs éléments de la colonne III du tableau périodique des éléments, par exemple du gallium Ga, de l'aluminium Al et/ou de l'indium In). La première puce 10, à base de silicium, constitue un support bien adapté pour réaliser un ou des composants permettant une montée en fréquence des signaux, et permettant de générer un signal à très haute fréquence. Ici, par exemple, la première puce 10 comprend un pré-amplificateur 11 (« pre-power amplifier PPA », en anglais), qui délivre un signal (par exemple sous la forme d'une tension électrique) à la fréquence f mentionnée plus haut.

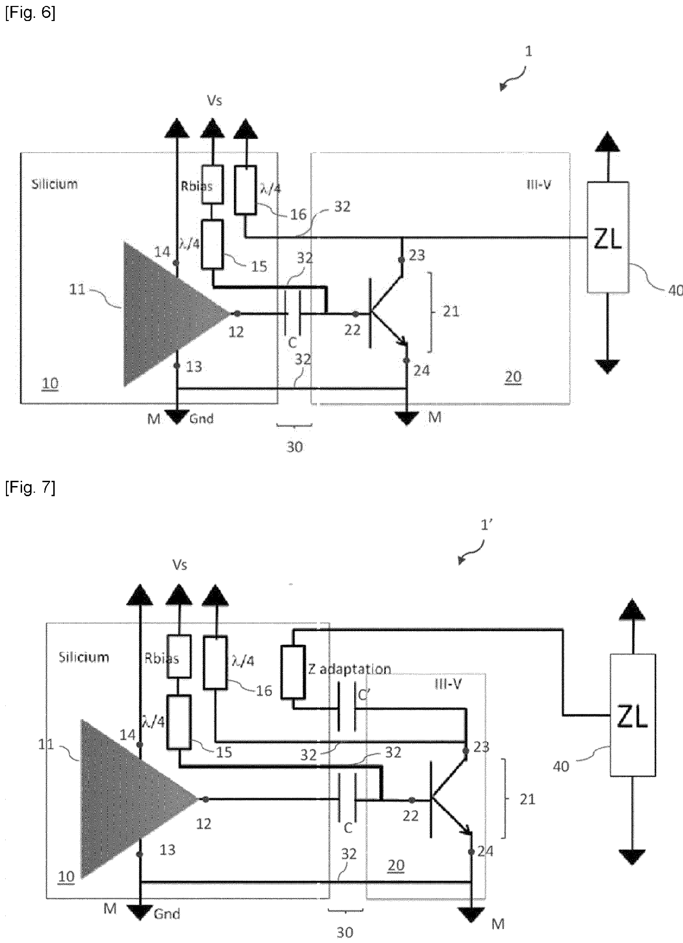

Quant à la deuxième puce 20, elle constitue un support bien adapté pour réaliser un ou des composants permettant une amplification de puissance à ces fréquences très élevées, avant d'émettre le signal ainsi amplifié, au moyen d'une antenne rayonnante 40. Ici, la deuxième puce 20 intègre un amplificateur de puissance 21 (« power amplifier PA ») adapté à ces fréquences, réalisé par exemple sous la forme d'un transistor (voir la figure 6).

La première puce 10 et la deuxième puce 20 sont assemblées l'une sur l'autre, parallèlement entre elles, pour former un empilement tridimensionnel. La première puce 10 présente une première surface 11 (surface supérieure de la première puce, ici), et la deuxième puce 20 présente une deuxième surface 21 (surface inférieure de la deuxième puce, ici), qui fait face à la première surface 11. Les deux puces sont ainsi assemblées l'une à l'autre avec leurs surfaces 11 et 21 en vis-à-vis l'une de l'autre.

La première surface 11 correspond plus précisément à la surface libre de la première puce 10 avant assemblage, micropoteaux et structure d'assemblage non-compris. Il s'agit d'une surface plane (en l'occurrence, il s'agit du plan moyen de la surface libre présentée par la puce 10 avant assemblage). De même, la deuxième surface 21 est la surface libre de la deuxième puce avant assemblage 20, micropoteaux et structure d'assemblage non-compris.

Une zone de jonction entre puces, 30, s'étend de la première surface 11 à la deuxième surface 21. Cette zone de jonction, qui est une zone d'assemblage entre puces, comprend des éléments de liaison entre puces permettant de les solidariser l'une avec l'autre. Ces éléments de liaison comprennent des micropiliers complets, 32, qui s'étendent de la première puce 10 jusqu'à la deuxième puce 20 (et qui sont formés chacun par deux micropoteaux, ou « posts » raccordés par exemple par une microbille de soudure). Un matériau de remplissage 31 (généralement appelé « undefill » dans ce domaine technique), optionnel, par exemple à base de polymères, peut remplir la partie inoccupée de la zone d'assemblage 30 pour obtenir un assemblage plus robuste mécaniquement.

Les micropiliers complets 32 permettent aussi de relier électriquement la première puce 10 à la deuxième puce 20 pour transmettre d'une puce à l'autre des tensions ou courants d'alimentation de composants électroniques (voir les figures 6 et 7), ou des signaux continus (connexions DC) ou basse-fréquence (de fréquence bien inférieure à 100, voire 10 ou même 1 GHz). En effet, ici, chacun des micropiliers 32 est conducteur, et permet ainsi une conduction électrique d'une puce à l'autre.

La première puce 10 est reliée aussi à la deuxième puce 20 par un condensateur de couplage, C, situé dans la zone de jonction 30. Ce condensateur relie ici le préamplificateur 11 de la première puce à l'amplificateur de puissance 21 de la deuxième puce 20, afin de transférer le signal à très haute fréquence mentionné plus haut, d'une puce à l'autre.

Pour cette liaison capacitive, on souhaite obtenir une impédance Z petite par rapport à l'impédance caractéristique des lignes de transmission, qui est ici de 50 Ohms. Cela permet en effet de limiter les pertes par retour R_{L} (pertes dues à la réflexion sur la liaison capacitive). Le tableau 1 ci-dessous rassemble quelques valeurs de l'impédance Z associée à une telle liaison capacitive, à une fréquence de 300 GHz, pour différentes valeurs de la capacité du condensateur de couplage C. Dans ce tableau, les pertes par retour sont exprimées en décibels, soit R_{L}(dB) = 20 log [((50+Z)-50)/(50+Z+50)], Z étant exprimée en Ohms.

**[Table 1]**

| Tableau 1 | | |
|---|---|---|
| C (fF) | Z @ 300 GHz (Ohms) | R_{L} (dB) |
| 50 | 10,6 | -20 |
| 100 | 5,3 | -26 |
| 200 | 2,6 | -32 |
| 500 | 1 | - 40 |

Comme illustré par ces valeurs, si l'on souhaite des pertes par retour inférieures à 20 décibels (Z inférieure à 10 Ohms environ), il est souhaitable que la capacité du condensateur de couplage C soit supérieure à 50 fF. Par ailleurs, en termes d'encombrement, une surface occupée inférieure à 100×100µm² est généralement souhaitable pour un tel composant. La capacité par unité de surface souhaitée est donc typiquement supérieure ou égale à 5 pF/mm².

Comme on va le voir ci-dessous, de telles valeurs peuvent effectivement être obtenues en réalisant ce condensateur de couplage à partir d'armatures pourvues de micropoteaux, pour des paramètres dimensionnels réalistes pour ce type de technologie. Le condensateur de couplage C employé dans cet exemple est maintenant décrit plus en détail, en référence aux figures 3 à 5.

Ce condensateur comprend :
- une première armature conductrice, 100, en contact électrique avec la première puce 10 (plus précisément, ici, en contact électrique avec une borne de sortie 12 du préamplificateur 11) , et
- une deuxième armature conductrice 200, en contact électrique avec la deuxième puce 20 (plus précisément, ici, en contact électrique avec une borne d'entrée 22, par exemple une grille, de l'amplificateur de puissance 21).

Les première et deuxième armatures sont isolées électriquement l'une de l'autre, c'est-à-dire qu'elle sont séparées l'une de l'autre par un isolant (qu'il s'agisse d'air ou d'un matériau solide isolant tel que le matériau de remplissage 31 à base de polymères mentionné plus haut).

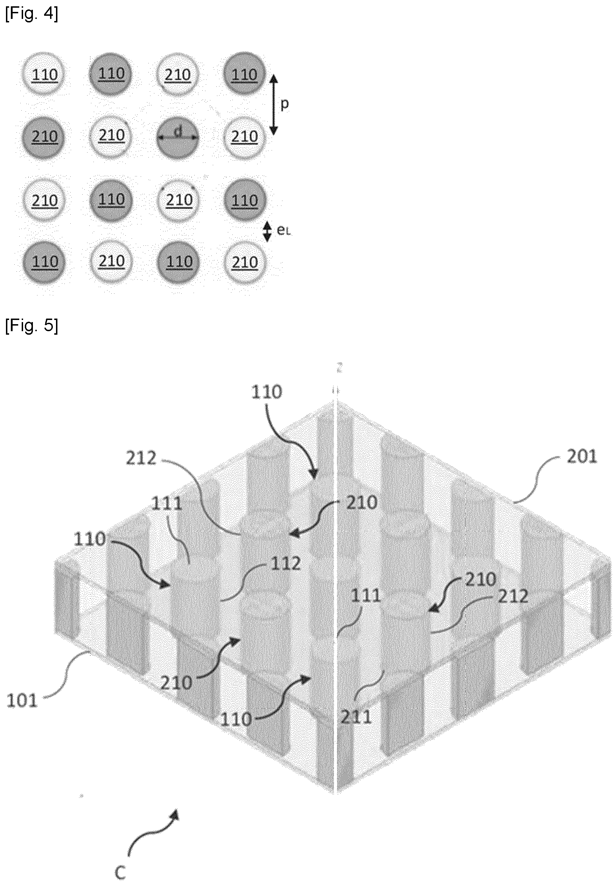

La première armature 100 comprend une première plaque 101 conductrice, par exemple en métal (parfois appelée « pad » dans ce domaine technique), qui s'étend parallèlement à la première surface 11, contre la première puce 10, par exemple contre la première surface 11, ou éventuellement légèrement en retrait par rapport à celle-ci. La première armature 100 comprend aussi des micropoteaux conducteurs, 110, qui s'étendent à partir de la première plaque 101, en direction de la deuxième puce 20 (voir les figures 3 et 5).

De même, la deuxième armature 200 comprend une deuxième plaque 201 conductrice, ou « pad », qui s'étend parallèlement à la deuxième surface 21, contre la deuxième puce 20, par exemple contre la deuxième surface 21 (ou éventuellement légèrement en retrait par rapport à celle-ci). La première armature 200 comprend elle aussi des micropoteaux conducteurs, 210, qui s'étendent à partir de la deuxième plaque 201, en direction de la première puce 10.

Dans ce premier mode de réalisation, les micropoteaux 210 de la deuxième armature sont décalés latéralement par rapport aux micropoteaux 110 de la première armature et s'étendent presque jusqu'à la première plaque 101, tandis que les micropoteaux 110 de la première armature s'étendent presque jusqu'à la deuxième plaque 201. Les micropoteaux 110 et 210 sont ainsi intercalés les uns avec les autres, avec leurs surfaces latérales respectives situées en vis-à-vis. Cette disposition permet d'augmenter la surface sur laquelle les deux armatures sont en influence électrique l'une avec l'autre, en exploitant aussi les surfaces latérales 112, 212 des micropoteaux 110, 210. Autrement formulé, cela permet d'augmenter la surface effective du condensateur C, et donc sa capacité électrique.

Comme on peut le voir sur la figure 3, chaque micropoteau 110 s'étend à partir de la première plaque 101, en direction de la deuxième puce, jusqu'à une face d'extrémité 111. L'axe du micropoteau est perpendiculaire à la première puce tandis que sa face d'extrémité 111 est parallèle à la première puce. La face d'extrémité 111 du micropoteau est située à une distance réduite de la deuxième plaque 201 (en l'occurrence, à une distance petite par rapport à l'épaisseur de la zone de jonction 30). Cette distance, notée ez, est par exemple inférieure à 2 ou même à 0,5 microns. Elle peut par exemple être comprise entre 0,1 et 0,5 micron. Pour chaque micropoteau 110, la face d'extrémité 111 du micropoteau s'étend ainsi en vis-à-vis et à distance réduite d'une portion plane 202 de la deuxième armature, plus précisément en face d'une petite portion de la deuxième plaque 201 de cette armature.

De la même manière, chaque micropoteau 210 s'étend à partir de la deuxième plaque 201, en direction de la première puce 10, jusqu'à une face d'extrémité 211 du micropoteau. L'axe du micropoteau est perpendiculaire à la deuxième puce tandis que sa face d'extrémité 211 est parallèle à la deuxième puce. La face d'extrémité 211 du micropoteau est située à distance réduite de la première plaque 101. Cette distance est par exemple inférieure à 2 ou même à 0,5 micron (elle peut par exemple être comprise entre 0,1 et 0,5 micron). Elle peut être égale à la distance ez mentionnée plus haut. Pour chaque micropoteau 210, la face d'extrémité 211 du micropoteau s'étend ainsi en vis-à-vis et à distance réduite d'une portion plane 102 de la première armature, plus précisément en face d'une petite portion de la première plaque 101 de cette armature.

Comme indiqué plus haut, pour chaque micropoteau 110, une partie de la surface latérale 112 du micropoteau 110 est située en vis-à-vis de la surface latérale 212 de l'un des micropoteaux 210, les micropoteaux 110 et 210 étant intercalés les uns avec les autres.

Ici, les micropoteaux 110 de la première armature sont répartis périodiquement sur la première plaque 101 en formant un réseau régulier bidimensionnel. En l'occurrence, ce réseau a un motif en quinconce (motif qui est répété périodiquement), c'est-à-dire un motif en carré avec un micropoteau 110 à chaque sommet du carré et un micropoteau 110 en plus au centre du carré (figures 4 et 5).

Les micropoteaux 210 de la deuxième armature sont eux aussi répartis périodiquement, sur la deuxième plaque 201, en formant un réseau régulier bidimensionnel, en l'occurrence un réseau identique à celui de la première armature. Ces deux réseaux sont décalés latéralement l'un par rapport à l'autre de manière à s'imbriquer l'un avec l'autre. L'ensemble comprenant les micropoteaux 110 et 210 forme alors un réseau carré, de pas p, avec une alternance entre micropoteaux 110 et micropoteaux 210. Autrement formulé, sur chaque ligne, et sur chaque colonne de cette matrice de micropoteaux, on a un micropoteau 110, puis un micropoteau 210, puis un micropoteau 110, et ainsi de suite. Chaque micropoteau 210, sauf ceux situés aux coins du réseau, est ainsi intercalé entre plusieurs micropoteaux 110.

Les micropoteaux 110 et 210 sont ici cylindriques, de diamètre d. D'un point de vue latéral, ils sont donc séparés deux à deux par une distance e_{L} égale à p-d.

Une simulation numérique a été réalisée pour déterminer la capacité du condensateur C pour cette géométrie des armatures, dans un cas où (figure 5) :
- le diamètre d des micropoteaux vaut 10 microns tandis que leur hauteur est de 15 microns,
- le pas p vaut 20 microns,
- l'écart ez vaut 1 micron, et où
- chaque armature forme un carré de 80 microns de côté (avec donc huit micropoteaux par armature, et seize micropoteaux en tout).

Lorsque les armatures sont séparées par de l'air (permittivité relative εᵣ=1), la capacité du condensateur est alors estimée à 23 femtofarad (fF), soit 3,6 picoFarad par mm² (3,6 pF/mm²). Et lorsque l'espace entre armatures est rempli par un polymère de remplissage tel que du polyimide (pour lequel la permittivité relative εᵣ est de 3,5 environ aux fréquences considérées), la capacité du condensateur est alors estimée à 80 femtofarad (fF), soit 12,5 pF par mm².

Les exemples de valeurs données plus haut pour les dimensions des micropoteaux et leur espacement sont typiques de ce type de technologie d'assemblage (ces dimensions peuvent d'ailleurs être légèrement plus petites). On constate donc sur cet exemple que ce type de structure de condensateur permet effectivement d'obtenir une capacité par unité de surface adaptée à l'application visée, typiquement supérieure à 5, et même à 10 pF/mm², pour des dimensions réalistes en termes de fabrication.

En termes de dimensions, les micropiliers utilisés pour réaliser cette liaison capacitive peuvent avoir un diamètre d compris entre 10 et 50 microns, et une hauteur comprise elle aussi entre 10 et 50 microns. L'espacement latéral e_{L} entre micropiliers peut quant à lui être compris entre d et deux fois d. Les micropiliers peuvent être répartis avec une densité surfacique comprise par exemple entre 5% et 25%. Cette densité surfacique est égale à la section d'un micropilier, multipliée par le nombre N de micropiliers considérés et divisée par la surface totale sur laquelle sont répartis ces N micropiliers (surface occupée par ces N micropiliers). A titre d'exemple, pour un réseau carré, de pas p=2.d (soit e_{L}=d, ce qui correspond à type de structure dont la fabrication est bien maitrisée en pratique), cette densité surfacique est de 20%.

On pourra noter, en termes de fabrication, que ce type de structure autorise des tolérances assez importantes en termes d'alignement des deux puces l'une avec l'autre. En effet, si les deux puces sont décalées latéralement l'une par rapport à l'autre, par rapport à la configuration présentée plus haut (i.e. : si chaque micropoteau 210 n'est pas positionné exactement au milieu, entre deux micropoteaux 110), la valeur de capacité obtenues restera néanmoins proche de celle correspondant à un alignement parfait (autrement dit, la valeur de cette capacité est relativement insensible aux erreurs d'alignement latéral entre puces). En effet, en cas d'erreur d'alignement, chaque micropoteau 210 se trouverait un peu plus près de l'un des micropoteaux 110 (ce qui tendrait à augmenter la valeur de la capacité), mais, en contrepartie, il se trouverait aussi un peu plus loin de l'autre micropoteau 110 qui l'encadre (ce qui tendrait au contraire à diminuer la capacité en question, compensant au moins en partie l'augmentation en question, et limitant la variation de capacité due à ce désalignement).

Différentes variantes peuvent être apportées au condensateur C de ce premier mode de réalisation, par exemple en ayant recours à un autre type de réseau bidimensionnel, basé sur un autre motif (par exemple un motif triangulaire), ou encore en ayant recours à un autre agencement des micropoteaux, par exemple un agencement globalement concentrique ou en spirale. Par ailleurs, comme mentionné plus haut, des dimensions plus petites que celles de l'exemple numérique décrit ci-dessus sont envisageables, en particulier pour l'écart ez (ce qui conduirait à des valeurs de capacité plus grandes que dans l'exemple numérique en question).

La figure 6 représente schématiquement le circuit intégré 1 de la figure 2, sous la forme d'un schéma électrique équivalent.

Comme on peut le voir sur cette figure, une tension électrique d'alimentation Vs est appliquée sur une borne d'alimentation 13 du préamplificateur 11 de la première puce tandis que la masse électrique M du circuit est connectée à une borne de masse 14 du préamplificateur. La borne de sortie 12 du préamplificateur 11 est connectée quant à elle à la première armature 100 du condensateur de couplage C, par l'intermédiaire d'une ligne ou piste ayant par exemple une impédance de ligne de 50 Ohms.

De l'autre côté de la zone de jonction 30, la deuxième armature 200 du condensateur de couplage C est connectée à la borne d'entrée 22 de l'amplificateur de puissance 21 (via une ligne ayant une impédance de 50 Ohms). Cette borne d'entrée correspond en fait à la grille du transistor qui forme cet amplificateur, ici. La source 24 de ce transistor est connectée à la masse M, en l'occurrence en étant reliée à la masse de la première puce par l'intermédiaire d'un micropilier complet 32 (micropilier DC) traversant la zone de jonction 30. Le drain 23 du transistor 21 est connecté quant à lui à une antenne rayonnante 40, pour émettre le signal à très haute fréquence ainsi amplifié.

Le transistor est polarisé grâce à la tension d'alimentation Vs. Plus précisément, la tension Vs est appliquée au drain 23, tandis qu'une tension, réduite par une résistance d'ajustement R_{bias}, est appliquée à la grille 22. Pour cela, le drain 23 et la grille 22 sont reliés chacun à une source de tension d'alimentation, située sur la première puce (et qui délivre la tension Vs), par l'intermédiaire de micropiliers complets 32 (micropiliers DC) traversant la zone de jonction 30. Pour éviter que les signaux à très haute fréquence produits par le préamplificateur 11, et par l'amplificateur de puissance 21, ne remontent les lignes DC d'alimentation électrique, une ligne quart d'onde 15, 16 est connectée entre le micropilier 32 considéré et la source de tension d'alimentation en question, pour chacun de ces deux micropiliers 32. Chaque ligne quart d'onde 15, 16 est une portion de ligne de transmission ayant une longueur égale à λ/4, où λ est la longueur d'onde du signal en question.

La figure 7 représente, sous la forme d'un circuit électrique équivalent, un circuit intégré 1' selon un deuxième mode de réalisation. Le circuit intégré 1' est identique au circuit intégré 1 du premier mode de réalisation (représenté sur les figures 2 à 6), si ce n'est que le signal amplifié produit par l'amplificateur de puissance repasse par la première puce 10 avant d'être transmis à l'antenne rayonnante 40. Pour cela, un condensateur de couplage supplémentaire, C', est connecté au drain 23 du transistor de l'amplificateur de puissance. Ce condensateur de couplage C' est identique, ou tout au moins similaire au condensateur de couplage C présenté plus haut. Le drain 23 est ainsi relié à une deuxième armature de ce condensateur (par une ligne 50 Ohms) tandis que la première armature de ce condensateur est reliée à l'antenne rayonnante 40 par l'intermédiaire d'une impédance Z, réalisée sur la première puce 10, et permettant une adaptation d'impédance avec l'antenne. Les éléments du circuit 1' identiques, ou tout au moins correspondant à ceux du circuit 1 portent les mêmes références que pour le circuit 1 du premier mode de réalisation.

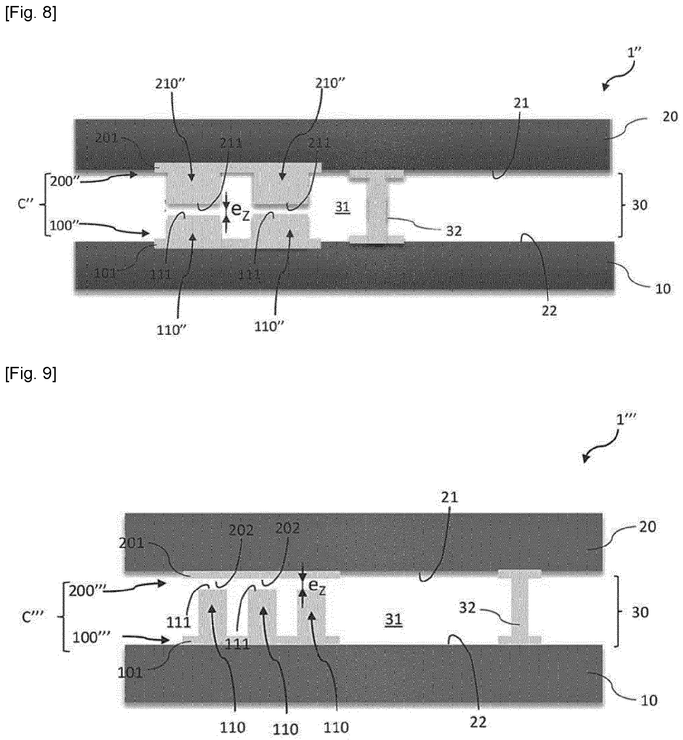

D'autres manières de réaliser un condensateur de couplage entre puces à partir d'un ou plusieurs micropoteaux, différentes de celle du premier mode de réalisation, peuvent être envisagées, comme on peut le voir sur les figures 8 et 9.

La figure 8 représente ainsi un circuit intégré 1" selon un troisième mode de réalisation, similaire au circuit 1 du premier mode de réalisation, mais dans lequel les micropoteaux 210" de la deuxième armature 200" s'étendent au droit des micropoteaux 110" de la première armature 100", au lieu d'être décalés latéralement par rapport à ceux-ci.

Pour le reste, le circuit intégré 1" est identique, ou tout au moins essentiellement identique au circuit intégré 1 du premier mode de réalisation. Les éléments identiques de ces deux modes de réalisation sont d'ailleurs repérés par les mêmes numéros de référence.

Le condensateur de couplage C" du circuit intégré 1" comprend, comme précédemment, une première armature 100" en contact électrique avec la première puce 10, et une deuxième armature 200" en contact électrique avec la deuxième puce 20. La première armature et la deuxième armature comprennent respectivement une première plaque 101 et une deuxième plaque 201, telles que présentées plus haut. Par ailleurs, elles comprennent chacune un ou plusieurs, ici plusieurs micropoteaux 110", 210".

Comme indiqué plus haut, les micropoteaux 210" s'étendent au droit des micropoteaux 110", c'est-à-dire en étant alignés avec les micropoteaux 110" selon une direction perpendiculaire aux puces. Les micropoteaux 210" ainsi que les micropoteaux 110" ont chacun une hauteur proche de la moitié de l'épaisseur de la zone de jonction 30, et légèrement inférieure à cette demi-épaisseur (alors que dans le premier mode de réalisation, les micropoteaux 110 et 210 avaient chacun une hauteur proche de l'épaisseur de la zone de jonction). Chaque couple de micropoteaux, regroupant l'un des micropoteaux 110" et le micropoteau 210" situé en face, forme ainsi une sorte de micropilier complet, mais sans microbille de soudure entre les deux micro-poteaux 110" et 210".

Chaque micropoteau 110" s'étend à partir de la première plaque 101, en direction de deuxième puce 20, jusqu'à une face d'extrémité 111 parallèle à la première puce. De même, chaque micropoteau 210" s'étend à partir de la deuxième plaque 201, en direction de première puce 10, jusqu'à une face d'extrémité 211 parallèle à la deuxième puce. Pour chaque couple de micropoteaux 110" et 210" situés en face l'un de l'autre, les faces d'extrémités respectives 111 et 211 des deux micropoteaux sont situées en face et à distance réduite l'une de l'autre. Elles sont parallèles l'une à l'autre. Et ici, elles se superposent entièrement l'une à l'autre. L'écart ez qui les sépare est ici inférieur à 2, voire même à 0,5 micron. Il peut par exemple être compris entre 0,1 et 0,5 micron.

Pour des micropoteaux de 10 microns de diamètre et un écart ez de 1 micron, on obtient, pour chaque couple de micropoteaux 110", 210", une capacité électrique élémentaire de 2,4 fF environ (avec, à tire d'exemple, du polyimide comme matériau de remplissage). Il faut alors vingt micropoteaux ou plus sur chaque armature (pour obtenir vingt couples 110"/210", ou plus) pour obtenir une capacité électrique totale supérieure ou égale à 50fF, pour le condensateur de couplage C". En supposant que les micropoteaux sont disposés selon un réseau carré, avec un pas de 20 microns, on obtient alors une capacité par unité de surface de 6 pF/mm² environ, ce qui est dans la gamme souhaitée. On constate donc là aussi que ce type de structure de condensateur permet d'obtenir une capacité par unité de surface adaptée à l'application visée (typiquement supérieure à 5 pF/mm²) pour des dimensions réalistes en termes de fabrication, d'autant que l'écart ez pourrait avoir une valeur inférieure à 1 micron, en pratique.

La figure 9 représente un circuit intégré 1‴ selon un quatrième mode de réalisation. Ce circuit intégré 1‴ est similaire au circuit 1 du premier mode de réalisation, mais il comprend un condensateur de couplage C"' dont la deuxième armature est dépourvue de micropoteau. Pour le reste, le circuit intégré 1"' est identique, ou tout au moins essentiellement identique au circuit intégré 1 du premier mode de réalisation. Les éléments identiques de ces deux modes de réalisation sont repérés par les mêmes numéros de référence.

Le condensateur de couplage C"' du circuit intégré 1‴ comprend, comme précédemment, une première armature 100"' en contact électrique avec la première puce 10, et une deuxième armature 200'" en contact électrique avec la deuxième puce 20. La première armature et la deuxième armature comprennent respectivement une première plaque 101 et une deuxième plaque 201 telles que présentées plus haut. Par ailleurs, la première armature 100'" comprend au moins un, ici plusieurs micropoteaux 110. En revanche, la deuxième armature 200‴ est dépourvue de micropoteau.

Les micropoteaux 110 de la première armature d'étendent en direction de la deuxième puce 20, depuis la première plaque 101 jusqu'à une face d'extrémité 111 parallèle à la première puce, et parallèle à la deuxième plaque 201. Pour chaque micropoteau 110, la face d'extrémité 111 du micropoteau s'étend ainsi en vis-à-vis et à distance réduite d'une portion plane 202 de la deuxième armature 200", plus précisément en face d'une petite portion de la deuxième plaque 201. Cette distance est là encore notée ez. Elle est par exemple inférieure à 2 microns, ou même inférieure à 0,5 micron (elle peut par exemple être comprise entre 0,1 et 0,5 micron).

La répartition des micropoteaux 110 sur la première plaque 101 peut être différente de la répartition des micropoteaux 110 présentée plus haut pour le premier mode de réalisation. En particulier, la densité surfacique de micropoteaux 110 peut être plus importante que dans le premier mode de réalisation (puisqu'il n'y a pas de micropoteaux appartenant à la deuxième électrode à intercaler entre les micropoteaux 110 de la première électrode).

Différentes variantes peuvent être apportées aux circuits intégrés qui viennent d'être présentés, en plus de celles déjà mentionnées.

Ainsi, les deux puces pourraient être réalisées à partir d'un même type de matériau semi-conducteur (par exemple du silicium) au lieu d'être réalisées à partir de deux types de matériaux différents. De plus, le circuit intégré pourrait comprendre une ou plusieurs autres puces, assemblées aux deux puces mentionnées plus haut pour former un empilement tridimensionnel plus complet (ces autres puces pouvant aussi être connectées au reste du circuit par l'intermédiaire d'un ou plusieurs condensateurs de couplage, réalisés dans une zone d'assemblage entre puces).

Par ailleurs, le condensateur de couplage mentionné plus haut pourrait servir à connecter entre eux d'autres composants que ceux mentionnés plus haut, et d'autres types de fonctions que les fonctions d'amplification présentées plus haut pourraient être implémentées dans un tel circuit intégré.

## Revendications

1. Circuit intégré (1 ; 1' ; 1" ; 1‴) comprenant une première puce (10) et une deuxième puce (20) assemblées l'une sur l'autre, la première puce étant connectée électriquement à la deuxième puce par un condensateur de couplage (C ; C' ; C" ; C‴) qui est situé dans une zone de jonction (30) entre puces, entre la première puce (10) et la deuxième puce (20), le condensateur de couplage comprenant :
- une première armature (100; 100" ; 100‴) conductrice, en contact électrique avec la première puce (10), et
- une deuxième armature (200 ; 200" ; 200"') conductrice en contact électrique avec la deuxième puce (20),
- une partie au moins de la première armature (100 ; 100" ; 100"') étant située en vis-à-vis de la deuxième armature (200 ; 200" ; 200"'), les première et deuxième armatures étant isolées électriquement l'une de l'autre,
- une partie au moins de la première armature (100 ; 100" ; 100"') étant formée par un ou plusieurs micropoteaux (110 ; 110") électriquement conducteurs qui s'étendent chacun à partir de la première puce (10), en direction de la deuxième puce (20) ;
le circuit intégré **caractérisé en ce que** :
- la première armature (100 ; 100" ; 100"') du condensateur de couplage (C ; C' ; C" ; C"') est reliée électriquement à un premier composant électronique (11 ; 40) de type transistor, diode, amplificateur, antenne, guide d'onde ou filtre, configuré pour générer, émettre, transmettre ou filtrer un signal électrique de fréquence supérieure ou égale à 10 GHz, voire à 300 GHz ;
- la deuxième armature (200 ; 200" ; 200"') est reliée électriquement à un deuxième composant électronique (21) de type transistor, diode, amplificateur, antenne, guide d'onde ou filtre.

2. Circuit intégré (1 ; 1' ; 1" ; 1‴) selon la revendication 1, dans lequel :
- chaque micropoteau (110 ; 110") s'étend perpendiculairement à la première puce, depuis la première puce (10) jusqu'à une face d'extrémité (111) du micropoteau,
- la deuxième armature (200 ; 200" ; 200"') présente, pour chaque micropoteau (110 ; 110"), une face (211) ou une portion (202) de face plane située en vis-à-vis et à une distance (ez) réduite de la face d'extrémité (111) de ce micropoteau (110 ; 110").

3. Circuit intégré (1 ; 1' ; 1") selon l'une des revendications 1 ou 2, dans lequel une partie au moins de la deuxième armature (200 ; 200") est formée par un ou plusieurs micropoteaux supplémentaires (210 ; 210") électriquement conducteurs, qui s'étendent chacun en direction de la première puce (10), depuis la deuxième puce (20) jusqu'à une face d'extrémité (211) du micropoteau supplémentaire (210 ; 210").

4. Circuit intégré (1 ; 1') selon la revendication 3, dans lequel chaque micropoteau (110), ainsi que chaque micropoteau supplémentaire (210), est délimité latéralement par une surface latérale (112, 212), et dans lequel au moins certains des micropoteaux supplémentaires (210) sont décalés latéralement par rapport auxdits micropoteaux (110), leurs surfaces latérales (212) respectives étant situées chacune en vis-à-vis de la surface latérale (112) de l'un desdits micropoteaux (110).

5. Circuit intégré (1 ; 1') selon la revendication 4, dans lequel au moins certains desdits micropoteaux supplémentaires (210) sont intercalés entre des micropoteaux (110) de la première armature (100).

6. Circuit intégré (1") selon les revendications 1 et 3, dans lequel au moins certains des micropoteaux supplémentaires (210") s'étendent chacun en vis-à-vis de l'un desdits micropoteaux (110"), la face d'extrémité (211) du micropoteau supplémentaire (210") considéré étant située en vis-à-vis et à distance (ez) réduite d'une face d'extrémité (111) du micropoteau (110") correspondant, en étant isolée électriquement de la face d'extrémité (111) de ce micropoteau.

7. Circuit intégré (1‴) selon la revendication 2, dans lequel la deuxième armature (200‴) est dépourvue de micropoteau.

8. Circuit intégré (1 ; 1'; 1" ; 1‴) selon l'une des revendications précédentes, dans lequel lesdits micropoteaux (110 ; 110") sont disposés périodiquement en formant un réseau régulier.

9. Circuit intégré (1 ; 1' ; 1" ; 1‴) selon l'une des revendications précédentes, dans lequel une partie au moins (111) de la première armature (100 ; 100" ; 100"') est séparée de la deuxième armature (200 ; 200" ; 200"') par une distance (ez) inférieure à 2 microns, voire inférieure à 0,5 micron.

10. Circuit intégré (1 ; 1' ; 1" ; 1‴) selon l'une des revendications précédentes, dans lequel le condensateur de couplage (C ; C' ; C" ; C"') a une capacité électrique moyenne par unité de surface supérieure ou égale à 5 picofarad par millimètre carré.

11. Circuit intégré (1 ; 1' ; 1" ; 1‴) selon l'une des revendications précédentes, dans lequel le condensateur de couplage (C ; C' ; C" ; C"') a une capacité électrique supérieure ou égale à 50 femtofarad.

12. Circuit intégré (1 ; 1' ; 1" ; 1‴) selon l'une des revendications précédentes, dans lequel la première puce (10) est formée au moins en partie d'un premier type de matériau semi-conducteur tandis que la deuxième puce (20) est formée au moins en partie d'un deuxième type de matériau semi-conducteur différent du premier type de matériau semi-conducteur.

## Patentansprüche

1. Integrierte Schaltung (1; 1'; 1"; 1‴) mit einem ersten Chip (10) und einem zweiten Chip (20), die aufeinander montiert sind, wobei der erste Chip über einen Koppelkondensator (C; C'; C"; C"') elektrisch mit dem zweiten Chip verbunden ist, der sich in einem Verbindungsbereich (30) zwischen den Chips zwischen dem ersten Chip (10) und dem zweiten Chip (20) befindet, wobei der Koppelkondensator umfasst:
- eine erste leitfähige Armatur (100; 100"; 100‴), die in elektrischem Kontakt mit dem ersten Chip (10) steht, und
- eine zweite leitfähige Armatur (200; 200"; 200‴), die in elektrischem Kontakt mit dem zweiten Chip (20) steht,
- wobei mindestens ein Teil der ersten Armatur (100; 100"; 100‴) gegenüber der zweiten Armatur (200; 200"; 200"') angeordnet ist, wobei die erste und die zweite Armatur elektrisch voneinander isoliert sind,
- wobei mindestens ein Teil der ersten Armatur (100; 100"; 100^{‴}) durch einen oder mehrere elektrisch leitende Mikropfähle (110; 110") gebildet ist, die sich jeweils vom ersten Chip (10) in Richtung des zweiten Chips (20) erstrecken;
wobei die integrierte Schaltung **dadurch gekennzeichnet ist, dass**:
- die erste Armatur (100; 100"; 100‴) des Koppelkondensators (C; C'; C"; C"') mit einer ersten elektronischen Komponente (11; 40) vom Typ Transistor, Diode, Verstärker, Antenne, Wellenleiter oder Filter elektrisch verbunden ist, die so gestaltet ist, dass sie ein elektrisches Signal mit einer Frequenz von mindestens 10 GHz oder sogar 300 GHz erzeugt, aussendet, überträgt oder filtert;
- die zweite Armatur (200; 200"; 200"') mit einer zweiten elektronischen Komponente (21) vom Typ Transistor, Diode, Verstärker, Antenne, Wellenleiter oder Filter elektrisch verbunden ist.

2. Integrierte Schaltung (1; 1'; 1"; 1‴) nach Anspruch 1, in der:
- sich jeder Mikropfahl (110; 110") senkrecht zum ersten Chip vom ersten Chip (10) bis zu einer Endfläche (111) des Mikropfahls erstreckt,
- die zweite Armatur (200; 200"; 200‴) für jeden Mikropfahl (110; 110") eine Fläche (211) oder einen ebenen Flächenabschnitt (202) aufweist, die bzw. der der Endfläche (111) dieses Mikropfahls (110; 110") gegenüberliegt und in einem reduzierten Abstand (e_{z}) von dieser angeordnet ist.

3. Integrierte Schaltung (1; 1'; 1") gemäß einem der Ansprüche 1 oder 2, in der mindestens ein Teil der zweiten Armatur (200; 200") durch einen oder mehrere zusätzliche elektrisch leitende Mikropfähle (210; 210") gebildet ist, die sich jeweils in Richtung des ersten Chips (10) vom zweiten Chip (20) bis zu einer Endfläche (211) des zusätzlichen Mikropfahls (210; 210") erstrecken.

4. Integrierte Schaltung (1; 1') nach Anspruch 3, in der jeder Mikropfahl (110) sowie jeder zusätzliche Mikropfahl (210) seitlich durch eine Seitenfläche (112, 212) begrenzt ist und bei der mindestens einige der zusätzlichen Mikropfähle (210) seitlich gegenüber den Mikropfählen (110) versetzt sind, wobei ihre jeweiligen Seitenflächen (212) jeweils der Seitenfläche (112) eines der Mikropfähle (110) gegenüberliegen.

5. Integrierte Schaltung (1; 1') nach Anspruch 4, in der mindestens einige der zusätzlichen Mikropfähle (210) zwischen Mikropfählen (110) der ersten Armatur (100) eingefügt sind.

6. Integrierte Schaltung (1") gemäß den Ansprüchen 1 und 3, in der sich mindestens einige der zusätzlichen Mikropfähle (210") jeweils gegenüber einem der Mikropfähle (110") erstrecken, wobei die Endfläche (211) des betreffenden zusätzlichen Mikropfahls (210") gegenüber einer Endfläche (111) des entsprechenden Mikropfahls (110") angeordnet ist und einen reduzierten Abstand (e_{z}) zu dieser aufweist, wobei sie elektrisch von der Endfläche (111) dieses Mikropfahls isoliert ist.

7. Integrierte Schaltung (1‴) gemäß Anspruch 2, in der die zweite Armatur (200‴) keinen Mikropfahl aufweist.

8. Integrierte Schaltung (1; 1'; 1"; 1‴) gemäß einem der vorstehenden Ansprüche, in der die Mikropfähle (110; 110") periodisch angeordnet sind und ein regelmäßiges Gitter bilden.

9. Integrierte Schaltung (1; 1'; 1"; 1‴) gemäß einem der vorstehenden Ansprüche, in der mindestens ein Teil (111) der ersten Armatur (100; 100"; 100‴) von der zweiten Armatur (200; 200"; 200"') durch einen Abstand (e_{z}) von weniger als 2 Mikrometern oder sogar weniger als 0,5 Mikrometern getrennt ist.

10. Integrierte Schaltung (1; 1'; 1"; 1‴) gemäß einem der vorstehenden Ansprüche, wobei der Koppelkondensator (C; C'; C"; Cm) eine mittlere elektrische Kapazität pro Flächeneinheit von mindestens 5 Picofarad pro Quadratmillimeter aufweist.

11. Integrierte Schaltung (1; 1'; 1"; 1‴) nach einem der vorstehenden Ansprüche, in der der Koppelkondensator (C; C'; C"; C‴) eine elektrische Kapazität von mindestens 50 Femtofarad aufweist.

12. Integrierte Schaltung (1; 1'; 1"; 1‴) nach einem der vorstehenden Ansprüche, in der der erste Chip (10) zumindest teilweise aus einem ersten Halbleitermaterialtyp gebildet ist, während der zweite Chip (20) zumindest teilweise aus einem zweiten Halbleitermaterialtyp gebildet ist, der sich von dem ersten Halbleitermaterialtyp unterscheidet.

## Claims

1. Integrated circuit (1; 1'; 1"; 1‴) comprising a first chip (10) and a second chip (20) assembled one on each other, the first chip being electrically connected to the second chip through a coupling capacitor (C; C'; C"; C‴) which is located in an inter-chip junction zone (30) between the first chip (10) and the second chip (20), the coupling capacitor comprising:
- a first conductive armature (100; 100"; 100‴) in electrical contact with the first chip (10), and
- a second conductive armature (200; 200"; 200‴) in electrical contact with the second chip (20),
- at least one part of the first armature (100; 100"; 100‴) being facing the second armature (200; 200"; 200‴), the first and second armatures being electrically insulated from each other,
- at least one part of the first armature (100; 100"; 100‴) being formed by one or more electrically conductive microposts (110; 110") which each extend from the first chip (10) in the direction of the second chip (20);
the integrated circuit being **characterized in that**:
- the first armature (100; 100"; 100‴) of the coupling capacitor (C; C'; C"; C‴) is electrically connected to a first electronic component (11; 40) of the transistor, diode, amplifier, antenna, waveguide or filter type, configured to generate, emit, transmit or filter an electrical signal having a frequency greater than or equal to 10 GHz, or even 300 GHz;
- the second armature (200; 200"; 200‴) is electrically connected to a second electronic component (21) of the transistor, diode, amplifier, antenna, waveguide or filter type.

2. Integrated circuit (1; 1'; 1"; 1‴) according to claim 1, wherein:
- each micropost (110; 110") extends perpendicularly to the first chip, from the first chip (10) to an end face (111) of the micropost,
- the second armature (200; 200"; 200‴) has, for each micropost (110; 110"), a face (211) or a planar face portion (202) facing and at a reduced distance (ez) from the end face (111) of this micropost (110; 110").

3. Integrated circuit (1; 1'; 1") according to one of claims 1 or 2, wherein at least one part of the second armature (200; 200") is formed by one or more additional electrically conductive microposts (210; 210"), which each extend in the direction of the first chip (10), from the second chip (20) to an end face (211) of the additional micropost (210; 210").

4. Integrated circuit (1; 1') according to claim 3, wherein each micropost (110), as well as each additional micropost (210), is laterally delimited by a side surface (112, 212), and wherein at least some of the additional microposts (210) are laterally offset with respect to said microposts (110), their respective side surfaces (212) each being facing the side surface (112) of one of said microposts (110).

5. Integrated circuit (1; 1') according to claim 4, wherein at least some of said additional microposts (210) are sandwiched between microposts (110) of the first armature (100).

6. Integrated circuit (1") according to claims 1 and 3, wherein at least some of the additional microposts (210") each extend facing one of said microposts (110"), the end face (211) of the additional micropost (210") considered being facing and at a reduced distance (ez) from an end face (111) of the corresponding micropost (110"), by being electrically insulated from the end face (111) of this micropost.

7. Integrated circuit (1‴) according to claim 2, wherein the second armature (200‴) is free of micropost.

8. Integrated circuit (1; 1'; 1"; 1‴) according to one of the preceding claims, wherein said microposts (110; 110") are arranged periodically by forming a regular array.

9. Integrated circuit (1; 1'; 1"; 1‴) according to one of the preceding claims, wherein at least one part (111) of the first armature (100; 100"; 100‴) is separated from the second armature (200; 200"; 200‴) by a distance (ez) of less than 2 microns, or even less than 0.5 micron.

10. Integrated circuit (1; 1'; 1"; 1‴) according to one of the preceding claims, wherein the coupling capacitor (C; C'; C"; C‴) has an average electric capacitance per unit area greater than or equal to 5 picofarads per square millimetre.

11. Integrated circuit (1; 1'; 1"; 1‴) according to one of the preceding claims, wherein the coupling capacitor (C; C'; C"; C‴) has an electric capacitance greater than or equal to 50 femtofarads.

12. Integrated circuit (1; 1'; 1"; 1‴) according to one of the preceding claims, wherein the first chip (10) is at least partly formed by a first type of semiconductor material while the second chip (20) is at least partly formed by a second type of semiconductor material different from the first type of semiconductor material.
